(19)

Europäisches Patentamt
European Patent Office
Office européen des brevets

(11) **EP 4 489 540 A1**

(12) **EUROPEAN PATENT APPLICATION**
published in accordance with Art. 153(4) EPC

(43) Date of publication:
**08.01.2025 Bulletin 2025/02**

(21) Application number: **22929927.6**

(22) Date of filing: **20.10.2022**

(51) International Patent Classification (IPC):
**H05K 9/00** *(2006.01)*    **B32B 15/01** *(2006.01)*
**H01F 1/14** *(2006.01)*

(52) Cooperative Patent Classification (CPC):
**B32B 15/01; H01F 1/14; H05K 9/00**

(86) International application number:
**PCT/JP2022/039178**

(87) International publication number:
**WO 2023/166783 (07.09.2023 Gazette 2023/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.03.2022 JP 2022032141**

(71) Applicant: **JX Advanced Metals Corporation Tokyo 105-8417 (JP)**

(72) Inventors:
• **ORI, Yuki**
  **Hitachi-shi, Ibaraki 317-0056 (JP)**
• **YAMAMOTO, Yukito**
  **Hitachi-shi, Ibaraki 317-0056 (JP)**
• **YOKOYAMA, Kohei**
  **Hitachi-shi, Ibaraki 317-0056 (JP)**

(74) Representative: **Mewburn Ellis LLP**
  **Aurora Building**
  **Counterslip**
  **Bristol BS1 6BX (GB)**

(54) **ELECTROMAGNETIC WAVE SHIELDING MATERIAL, COVERING MATERIAL OR EXTERIOR MATERIAL, AND ELECTRIC/ELECTRONIC APPARATUS**

(57)    Provided is an electromagnetic wave shielding material having a good shielding property in a low frequency range. The electromagnetic wave shielding material has a structure in which at least one ferromagnetic layer and at least one non-magnetic conductive metal layer is laminated together, wherein the electromagnetic wave shielding material further includes a treated film containing an alloy including copper and nickel on at least one surface of the non-magnetic conductive metal layer.

**EP 4 489 540 A1**

**Description**

FIELD OF THE INVENTION

The present invention relates to an electromagnetic wave shielding material, a covering material or an external material, and an electric/electronic apparatus.

BACKGROUND OF THE INVENTION

Many environmentally friendly vehicles equipped with secondary batteries, such as electric vehicles and hybrid vehicles, use a system in which the DC current generated by the installed secondary batteries is converted to AC current via an inverter, and the necessary power is then supplied to an AC motor to obtain driving power, and electromagnetic waves are generated due to the switching operation of the inverter, and the like.

In addition, electromagnetic waves are emitted from many electrical and electronic apparatuses, including communication devices, displays, and medical devices, in addition to automobiles. The electromagnetic waves can cause malfunctions in precision devices, and there are also concerns about their effects on the human body.

Typically, in a higher frequency range (1 MHz or more), conductive layers such as copper are known to exhibit good shielding properties against the electromagnetic waves. However, in a lower frequency range (1 MHz or less), only the conductive layer such as copper results in lower shielding properties against the electromagnetic waves, so it is known that electromagnetic wave shielding materials having alternating layers of magnetic and conductive layers with excellent magnetic permeability exhibit good shielding properties against magnetic waves.

The following technique is proposed in Patent Literature 1, for example: "A noise suppression sheet used to suppress a noise of 1 MHz or more, the noise suppression sheet comprising: a noise suppression layer having n magnetic layers having a magnetic layer ($A_1$) and a magnetic layer ($A_n$); and at least (n-1) conductive layers, the magnetic layers and the conductive layers being alternately laminated, wherein each of the magnetic layers has $X_i$ expressed in the following equation (1) of 1 or more,

wherein the total of $X_i$ of the magnetic layers is 4 or more and 15 or less, and
each of the conductive layers has a proportionality constant of 4 or more obtained when linearly approximating a shielding property of 0.2 to 1 MHz in magnetic field shielding measurement using an KEC method:

$$X_i = \sqrt{\mu'_i} \times \sqrt{t_i} \qquad \text{Equation (1)}$$

in which n is an integer greater than or equal to 2, i is an integer greater than or equal to 1 and less than or equal to n, $\mu'_i$ is a relative magnetic permeability at 1 MHz of the magnetic layer (Ai), and $t_i$ is a thickness of the magnetic layer ($A_i$) [mm]."

CITATION LIST

Patent Literature

[Patent Literature 1] Japanese Patent Application Publication No. 2021-028940 A

SUMMARY OF THE INVENTION

[Technical Problem]

The noise suppression sheet described in Patent Literature 1 shows high shielding performance in the low frequency range. However, while some product fields require high shielding performance in the range of about 100 kHz, the noise suppression sheet described in Patent Literature 1 mentions shielding performance at 300 kHz (see paragraphs [0110] and [0111] in Patent Literature 1), but it does not mention shielding performance in the low frequency range. Therefore, it is not clear whether the noise suppression sheet described in Patent Literature 1 has sufficient shielding performance in the low frequency region lower than 300 kHz, and there is still room for improvement in the technique of Patent Literature 1.

Therefore, in one embodiment of the present invention, an object of the present invention is to provide an electromagnetic wave shielding material having a good shielding property in the low frequency range.

[Solution to Problem]

Thus, in an aspect, the present invention relates to an electromagnetic wave shielding material having a structure in which at least one ferromagnetic layer and at least one non-magnetic conductive metal layer is laminated together, wherein the electromagnetic wave shielding material further comprises a treated film containing an alloy comprising copper and nickel on at least one surface of the non-magnetic conductive metal layer.

In one embodiment of the electromagnetic wave shielding material according to the present invention, the structure has ferromagnetic layers laminated via at least two non-magnetic conductive metal layers.

In one embodiment of the electromagnetic wave shielding material according to the present invention, at least one outermost layer is the non-magnetic conductive metal layer.

In one embodiment of the electromagnetic wave shielding material according to the present invention, the alloy contained in the treated layer further comprises cobalt.

In one embodiment of the electromagnetic wave shielding material according to the present invention, a mass ratio of cobalt in each treated film is 1.50 to 4.50 assuming that the mass ratio of nickel in each treated layer is 1.

In another aspect, the present invention relates to a covering material or an exterior material for electrical and electronic apparatuses, the covering material or the exterior material comprising any one of the above electromagnetic wave shielding materials.

Furthermore, in another aspect, the present invention relates to an electrical and electronic apparatus comprising the covering material or the exterior material as described above.

[Advantageous Effects of Invention]

According to one embodiment of the invention, it is possible to provide an electromagnetic wave shielding material having a good shielding property in a low frequency range.

[Description of Embodiments]

The present invention is not limited to each of the following embodiments, but it can be embodied by modifying its components to the extent that it does not depart from the spirit of the present invention. Also, various inventions can be formed by appropriate combinations of a plurality of components disclosed in each embodiment.

[Electromagnetic Wave Shielding Material]

In one embodiment of the electromagnetic wave shielding material according to the present invention, it has a structure in which at least one ferromagnetic layer and at least one non-magnetic conductive metal layer are laminated together. Especially, in one embodiment, the structure preferably has ferromagnetic layers laminated via at least two non-magnetic conductive metal layers, from the viewpoint of shielding properties. Furthermore, it is preferable that at least one outermost layer (the uppermost layer and/or the lowermost layer) of the electromagnetic wave shielding material is the non-magnetic conductive metal layer, and that both of the outermost layers are the non-magnetic conductive metal layers, from the viewpoint of shielding properties.

Then, the electromagnetic wave shielding material has further has a treated film of an alloy containing copper and nickel on at least one surface of the non-magnetic conductive metal layer, but it is preferable to further have the above treated films on both of the surfaces of the non-magnetic conductive metal layer. In this case, it is preferable that the treated film is disposed via the ferromagnetic layer and the non-magnetic conductive metal layer, from the viewpoint of efficient absorption and attenuation of electromagnetic waves in the ferromagnetic layer. From the viewpoint of shielding properties, it is also preferable that at least one outermost film (uppermost film and/or lowermost film) of the electromagnetic wave shielding material is a treated film formed on the non-magnetic conductive metal layer. The treated film disposed via the ferromagnetic layer and the non-magnetic conductive metal layer includes not only the mode where it is formed on at least one surface of the non-magnetic conductive metal layer, but also a mode where it is formed on a surface of the non-magnetic conductive metal layer side of the ferromagnetic layer adjacent to the non-magnetic conductive metal layer.

The electromagnetic shielding material exhibits a good shielding property in the low frequency range due to these configurations. Although not wishing to be bound by any theory, we believe that this would be due to the following reasons. When the non-magnetic conductive metal layer is irradiated with electromagnetic waves, some of them pass through, but some are reflected. As an example, if the ferromagnetic layer is configured to the ferromagnetic layer between two non-magnetic conductive metal layers, the electromagnetic waves repeatedly reflected between the non-magnetic conductive metal layers (multipath reflection) can be absorbed in the magnetic material, thereby providing a better shielding effect than that of the non-magnetic conductive metal layer alone or the ferromagnetic material alone. In particular, a roughening and plating process of at least one surface of the non-magnetic conductive metal layer to form the treated film containing an alloy including Cu-Ni leads to diffuse reflection, rather than specular reflection that will typically occur in the non-magnetic conductive metal layer having metallic luster, so that the absorption and attenuation of electromagnetic waves in the ferromagnetic layer can be efficiently caused.

<Ferromagnetic Layer>

The ferromagnetic layer contains a material having high magnetic permeability. Examples of the material include composite sheets with resins mixed and dispersed therein, metal foils, and laminates having high magnetic permeability while laminating a resin sheet on at least one surface of a metal foil. The ferromagnetic layer generally has a specific magnetic permeability of from 10 to 100,000.

It should be noted that the specific magnetic permeability can be measured using a commercially available magnetic permeability measuring device.

The resin includes natural and synthetic resins, and the synthetic resins are preferred from the viewpoint of processability. These materials can also be mixed with fiber-reinforced materials such as carbon fiber, glass fiber and aramid fiber.

The synthetic resins include polyesters such as PET (polyethylene terephthalate), PEN (polyethylene naphthalate) and PBT (polybutylene terephthalate); olefinic resins such as polyethylene and polypropylene; polyamides; polyimides; liquid crystal polymers; polyacetals; fluororesins; polyurethanes; acrylic resins; epoxy resins; silicone resins; phenol resins; melamine resins; ABS resins; polyvinyl alcohols; urea resins; polyvinyl chloride; PC (polycarbonate); polystyrenes; styrene butadiene rubbers, etc., from the viewpoint of availability and processability, and among these, PET, PEN, polyamide, and polyimide are preferred for reasons of processability and costs. The synthetic resins can also be elastomers such as urethane rubbers, chloroprene rubbers, silicone rubbers, fluororubbers, styrene-based, olefin-based, polyvinyl chloride-based, urethane-based, and amide-based elastomers. Furthermore, the synthetic resin itself may play the role of an adhesive, and in this case, it forms a structure in which the non-magnetic conductive metal layers with the treated films formed on the surface is laminated via the adhesive. Non-limiting examples of the adhesives include acrylic resin-based, epoxy resin-based, urethane-based, polyester-based, silicone resin-based, vinyl acetate-based, styrene butadiene rubber-based, nitrile rubber-based, phenol resin-based, and cyanoacrylate-based adhesives, and the urethane-based, polyester-based, and vinyl acetate-based adhesives are preferred for the reasons of ease of production and costs.

The composite sheet can be laminated in a form of a film or fiber. The composite sheet can also be formed by applying an uncured resin composition on the non-magnetic conductive metal layer or the treated film and then curing it, but a composite sheet that can be affixed to the non-magnetic conductive metal layer or the treated film is preferred for reasons of ease of production. The PET film is particularly suitable. In particular, the strength of the electromagnetic wave shielding material can be increased by using a biaxially oriented film as the PET film.

When the ferromagnetic layer is a metal foil, the ferromagnetic layer is more preferably a metal foil containing at least one selected from nickel, iron, Permalloy (Ni-Fe alloy) and Sendust (Fe-Si-Al alloy). Since these materials have relatively high magnetic permeability, they can collect the magnetic flux components in the noise and reduce the spatial magnetic field.

<Non-magnetic Conductive Metal Layer>

The non-magnetic conductive metal layer is composed of a conductive metal material that exhibits antimagnetic or paramagnetic substances. In one embodiment, the material of the non-magnetic conductive metal layer to be used is not particularly limited, but from the viewpoint of enhancing shielding properties with respect to alternating magnetic fields and alternating electric fields, it is preferably a metal material with improved electrical conductivity. Specifically, it is preferably formed of a material having an electrical conductivity of $1.0 \times 10^6$ S/m (which is a value at 20°C; the same applies hereinafter) or more, and more preferably an electrical conductivity of $10.0 \times 10^6$ S/m or more, and even more preferably an electrical conductivity of $30.0 \times 10^6$ S/m or more, and most preferably an electrical conductivity of $50.0 \times 10^6$ S/m or more. Such metals include aluminum having an electrical conductivity of about $39.6 \times 10^6$ S/m, copper having an electrical conductivity of about $58.0 \times 10^6$ S/m, and silver having an electrical conductivity of about $61.4 \times 10^6$ S/m. In other words, it is suitable that the non-magnetic conductive metal layer contains one selected from aluminum, copper, and silver, and in view of both conductivity and cost, aluminum or copper is preferred for practicality. All the non-magnetic conductive metal layers used in the electromagnetic wave shielding material according to the present invention may employ the same metal, or different metals for each layer. Alloys of the above-mentioned metals may also be used.

The non-magnetic conductive metal layer is not limited to any particular shape, but an example is a metal foil. When copper foil is used as the non-magnetic conductive metal layer, it should be of high purity, and it preferably has a purity of 99.5% by mass or more, more preferably 99.8% by mass or more, as it improves shielding properties. A rolled copper foil, electrodeposited copper foil, and metallized copper foil can be used as the copper foil, and the rolled copper foil is preferred because of its superior bendability and formability. When alloying elements are added to the copper foil to make the copper alloy foil, the total content of these elements and unavoidable impurities may be less than 0.5% by mass. In particular, a total content of 50 to 2000 ppm by mass of at least one selected from tin, manganese, chromium, zinc, zirconium, magnesium, nickel, silicon, and silver, and/or 10 to 50 ppm by mass of phosphorus in the copper foil is/are preferable because it improves elongation compared to a pure copper foil having the same thickness.

<Treated Film>

From the viewpoint of enhancing shielding properties, the treated film includes an alloy containing copper and nickel formed on at least one surface of the non-magnetic conductive metal layer. In addition to copper and nickel, the treated film may also include an alloy further containing cobalt.

The treated film may, as an example, include an electromagnetic wave absorption auxiliary film of an alloy containing at least copper and nickel, and may further include one or more selected from heat resistant films, rust preventive films, and weather resistant films to the extent that the effect of present the invention is not hindered. In this case, the electromagnetic wave absorption auxiliary film may be made of an alloy containing not only copper and nickel but also cobalt. The heat resistant-treated heat resistant films include plated films and vapor-deposited films containing cobalt and/or nickel, and the like, and the rust preventive-treated rust preventive films include inorganic plated films and vapor-deposited films such as zinc and chromium, and organic films such as benzotriazole, and the silane coupling-treated weather resistant films include organic coated films containing silane coupling agents. In other words, one or more metals selected from cobalt, zinc, molybdenum, tin, phosphorus, tungsten, chromium, and silicon may be further included in the treated film in addition to copper and nickel.

In addition, when the ferromagnetic layer is a composite sheet or a metal foil containing a resin, the treated film interposed between the ferromagnetic layer and the non-magnetic conductive metal layer can also improve adhesiveness between the ferromagnetic layer and the non-magnetic conductive metal layer.

The electromagnetic wave absorption auxiliary film can be produced by known methods, such as plating, metal deposition, and sputtering. In particular, a method of forming an electromagnetic wave absorption auxiliary film containing copper and nickel by plating on the surface of the non-magnetic conductive metal layer is described below as an example.

In the plating process to form the electromagnetic wave absorption auxiliary film, a particle film consisting of copper and nickel is formed on at least one surface of the non-magnetic conductive metal layer, but a particle film consisting of copper, cobalt and nickel may be formed on at least one surface of the non-magnetic conductive metal layer.

(Plating Conditions (Roughening Plating Process) 1: Plating of Copper and Nickel Alloy)

An example of copper and nickel plating conditions is as follows:

Liquid composition: 10 to 20 g/L of copper, 5 to 15 g/L of nickel;
pH: 2 to 3;
Liquid temperature: 30 to 50 °C;
Current density: 10 to 65 A/dm$^2$; and
Coulomb amount: 10 to 50 As/dm$^2$.

(Plating Conditions (Roughening Plating Process) 2: Plating of Copper, Cobalt and Nickel Alloy)

An example of the plating conditions for copper, cobalt, and nickel is as follows:

Liquid composition: 10 to 20 g/L of copper, 5 to 15 g/L of cobalt, 5 to 15 g/L of nickel;
pH: 2 to 3;
Liquid temperature: 30 to 50 °C;
Current density: 10 to 65 A/dm$^2$; and
Coulomb amount: 10 to 48 As/dm$^2$.

In this case, the roughening plating process can be performed in multiple stages under the above plating conditions 1 and/or 2.

(Mass Ratio, Adhesion Amount)

When each treated film contains an alloy containing copper, cobalt and nickel, the mass ratio of cobalt in each treated film is preferably 1.50 to 4.50 assuming that the mass ratio of nickel in each treated film is 1. The lower limit of the above cobalt mass ratio is, for example, 1.50, 1.80, or 1.90. The upper limit of the above mass ratio of cobalt is, for example, 4.50, 4.20, or 4.20.

The mass ratio in the treated film containing the above alloy of copper, cobalt and nickel can be determined based on the following equation (1):

Mass ratio of cobalt in each treated film assuming that the mass ratio of nickel in each treated film is 1 = [amount of Co adhering on treated film ($\mu$g/dm$^2$)/ amount of Ni adhering on treated film ($\mu$g/dm$^2$)].    (1)

In the heat resistant treatment, at least one of the following heat resistant films 1-8 can be further formed on the electromagnetic wave absorption auxiliary film as described above. The respective plating and deposition conditions are shown below.

(Plating Conditions for Heat Resistant Film 1) (Co-Ni Plating: Plating of Cobalt-Nickel Alloy)

Liquid composition: 5 to 20 g/L of nickel, 1 to 8 g/L of cobalt;
pH: 2 to 3;
Liquid temperature: 40 to 60 °C;
Current density: 10 to 30 A/dm$^2$; and
Coulomb amount: 2 to 20 As/dm$^2$.

(Plating Conditions for Heat Resistant Film 2) (Ni-Zn Plating: Plating of Nickel-Zinc Alloy)

Liquid composition: 2 to 30 g/L of nickel, 2 to 30 g/L of zinc;
pH: 3 to 4;
Liquid temperature: 30 to 50 °C;
Current density: 1 to 10 A/dm$^2$; and
Coulomb amount: 0.5 to 2 As/dm$^2$.

(Plating Conditions for Heat Resistant Film 3) (Ni-Cu Plating: Plating of Nickel-Copper Alloy)

Liquid composition: 2 to 30 g/L of nickel, 2 to 30 g/L of copper;
pH: 3 to 4;
Liquid temperature: 30 to 50 °C;
Current density: 1 to 2 A/dm$^2$; and
Coulomb amount: 1 to 2 As/dm$^2$.

(Plating Conditions for Heat Resistant Film 4) (Ni-Mo Plating: Plating of Nickel-Molybdenum Alloy)

Liquid composition: Ni sulfate hexahydrate: 45 to 55 g/dm$^3$, sodium molybdate dihydrate: 50 to 70 g/dm$^3$, sodium citrate: 80 to 100 g/dm$^3$;
Liquid temperature: 20 to 40 °C;
pH: 1.5 to 4.5;
Current density: 1 to 4 A/dm$^2$; and
Coulomb amount: 1 to 2 As/dm$^2$.

(Plating Conditions for Heat Resistant Film 5) (Ni-Sn Plating: Plating of Nickel-Tin Alloy)

Liquid composition: 2 to 30 g/L of nickel, 2 to 30 g/L of tin;
pH: 1.5 to 4.5;
Liquid temperature: 30 to 50 °C;
Current density: 1 to 2 A/dm$^2$; and
Coulomb amount: 1 to 2 As/dm$^2$.

(Plating Conditions for Heat Resistant Film 6) (Ni-P Plating: Plating of Nickel-Phosphorus Alloy)

Liquid composition: 30 to 70 g/L of nickel, 0.2 to 1.2 g/L of phosphorus;
pH: 1.5 to 2.5;
Liquid temperature: 30 to 40 °C;
Current density: 1 to 2 A/dm$^2$; and
Coulomb amount: 1 to 2 As/dm$^2$.

(Plating Conditions for Heat Resistant Film 7) (Ni-W Plating: Plating of Nickel-Tungsten Alloy)

Liquid composition: 2 to 30 g/L of nickel, 0.01 to 5 g/L of tungsten;
pH: 3 to 4;
Liquid temperature: 30 to 50 °C;
Current density: 1 to 2 A/dm$^2$; and
Coulomb amount: 1 to 2 As/dm$^2$.

(Deposition Conditions for Heat Resistant Film 8) (Ni-Cr Deposition: Deposition of Nickel-Chromium Alloy)

A nickel-chromium alloy deposition film is formed using a sputtering target having a composition of 65 to 85 mass% of nickel and 15 to 35 mass% of chromium. Target: 65 to 85mass% of nickel, 15 to 35 mass% of chromium.

Equipment: Sputtering equipment manufactured by ULVAC Inc.
Output: DC 50W; and
Argon pressure: 0.2 Pa.

In the rust preventive treatment, the following rust preventive film and/or weather resistant film can be further formed on the electromagnetic wave absorption auxiliary film or the heat resistant film as described above. Each condition is shown below.

(Plating Conditions for Rust Preventive Film)

Liquid composition: 1 to 10 g/L of potassium dichromate, 0.2 to 0.5 g/L of zinc; pH: 3 to 4;
Liquid temperature: 50 to 70 °C;
Current density: 0 to 2 A/dm$^2$ (0 A/dm$^2$ is for immersion chromate treatment.); and
Coulomb amount: 0 to 2 As/dm$^2$ (0 As/dm$^2$ is for immersion chromate treatment.)

(Type of Weather Resistant Film (Silane Coupling Film))

One example is the application of an aqueous diaminosilane solution or an aqueous epoxysilane solution.
If the metal film or the plated film such as heat resistant films is provided by vapor deposition such as sputtering, and if the metal film or the plated film such as heat resistant films is provided by plating and the metal film or the plated film such as heat resistant films is normal plating (smooth plating, i.e., plating performed at a current density below limiting current density), the metal film or the plated film does not affect the shape of the surface of the copper foil.
Although the limiting current density varies depending on concentrations of metal, pH, feed rates, distances between poles, and temperatures of plating solutions, the limiting current density as used herein is defined as the current density at the boundary between normal plating (a plated metal is deposited in a form of film) and roughened plating (burnt plating; a plated metal is deposited in a form of crystal (in a form of spherical, needle, icicle, etc.); it has irregularities), and the current density (visually determined) at the limit of normal plating (just before burnt plating) in the Hull cell test is determined to be the limiting current density.

Specifically, the concentrations of the metals, pH, and the temperature of the plating solution are set to the production conditions for plating, and the Halsell test is conducted. The metal layer formation state (whether the plated metals are deposited in the form of layer or crystal) at the composition of the plating solution and at the temperature of the plating solution is then investigated. The current density at the boundary between normal plating and roughened plating is then determined from the position of the test piece where the boundary between normal plating and roughened plating exists, based on the current density quick reference table manufactured by YAMAMOTO-MS Co, Ltd. The current density at the boundary is then defined as the limiting current density. This gives the limiting current density at the composition of the plating solution and at the temperature of the plating solution. Generally, as a shorter distance between poles, the limiting current density tends to be higher.

The Halsell test method is described, for example, in "Plating Practice Handbook" by Kiyoshi Maruyama, June 30, 1983, pp. 157-160, Nikkan Kogyo Shimbun, Ltd.

When the plating process is performed below the limiting current density, the current density during the plating process is preferably less than or equal to 20 A/dm$^2$, more preferably less than or equal to 10 A/dm$^2$, even more preferably less than or equal to 8 A/dm$^2$.

Further, the rust preventive film and the weather resistant film do not affect the shape of the surface of the copper foil because of their extremely thin thickness.

An average thickness (L1) of each treated layer in the treated films can be set as needed, but the average thickness of each electromagnetic wave absorption auxiliary film is generally 0.001 $\mu$m to 0.8 $\mu$m, and the average thickness of each of other heat resistant films can be in the nanometer range. An average thickness (L2) of each non-magnetic conductive metal layer is not particularly limited and can be set as needed. For example, it is in the range of 1.2 $\mu$m to 150 $\mu$m. The lower limit of the average thickness (L2) is, for example, more than or equal to 5.0 $\mu$m, for example, more than or equal to 12 $\mu$m. The upper limit of the average thickness (L2) is, for example, less than or equal to 75 $\mu$m, for example, less than or equal to 50 $\mu$m.

An average thickness (L3) of each ferromagnetic layer is not particularly limited and can be set as needed. For example, it is in the range of 10 $\mu$m to 120 $\mu$m. The lower limit of the average thickness (L3) is, for example, more than or equal to 20 $\mu$m, and for example, more than or equal to 30 $\mu$m. The lower limit of the average thickness (L3) is, for example, less than or equal to 100 $\mu$m, for example, less than or equal to 60 $\mu$m.

As for the method of calculating the average thicknesses, for example, a STEM image can be obtained using a transmission electron microscope for L1, and the respective thicknesses can be measured using a thickness gauge for L2 and L3.

Although shielding properties are improved when the number of layers of the ferromagnetic layers and the non-magnetic conductive metal layers is larger, the production cost increases as the number of layers increases and the shielding improvement effect tends to be saturated. Therefore, the number of non-magnetic conductive metal layers in the electromagnetic wave shielding material may be 5 or less, and the number of ferromagnetic layers may be 4 or less.

The method of laminating the ferromagnetic layer and the non-magnetic conductive metal layer may be done by using an adhesive between the ferromagnetic layer and the non-magnetic conductive metal layer, or by thermocompression-bonding the ferromagnetic layer to the non-magnetic conductive metal layer without using any adhesive. The method of simply overlapping the layers without using any adhesive is also acceptable, but in view of the unity of the electromagnetic wave shielding material, it is preferable to join at least the edges (e.g., each side if the shielding material is square) by a tape or an adhesive, or by thermocompression bonding. However, from the viewpoint of not applying excess heat to the ferromagnetic layer, it is preferable to use an adhesive. The adhesive is as described above, including, but not limited to, acrylic resin-based adhesives, epoxy resin-based adhesives, urethane-based adhesives, polyester-based adhesives, silicone resin-based adhesives, vinyl acetate-based adhesives, styrene butadiene rubber-based adhesives, nitrile rubber-based adhesives, phenol resin-based adhesives, cyanoacrylate-based adhesives, and the like. Urethane-based adhesives, polyester-based adhesives, and vinyl acetate-based adhesives are preferred for reasons of ease of production and cost.

The thickness of the adhesive layer is preferably less than or equal to 100 $\mu$m. If the thickness of the adhesive layer is more than 100 $\mu$m, the stress on the non-magnetic conductive metal layer and the ferromagnetic layer, which are the adherend layers, increases when the layer is bent, leading to ease of breakage. However, if the adhesive layer also serves as the ferromagnetic layer as described above, this is not the case, and the thickness can be as defined in the description of the ferromagnetic layer.

According to one embodiment, it can have a magnetic field shielding property (how much the signal is attenuated on the receiving side) of 15 dB or more at 100 kHz, preferably 18 dB or more, more preferably 20 dB or more, even more preferably 24 dB or more, still more preferably 30 dB or more. In this invention, the magnetic field shielding property is measured by a KEC method. The KEC method refers to the "electromagnetic wave shielding property measurement method" in KEC Electronic Industry Development Center.

(Application)

In one embodiment, the present invention can be used for various electromagnetic wave shielding applications such as, particularly, covering or exterior materials for electrical and electronic apparatuses (e.g., inverters, communication devices, resonators, electron tubes and discharge lamps, electric heating devices, electric motors, generators, electronic components, printed circuits, medical devices, etc.), covering materials for harnesses and communication cables connected to electrical and electronic apparatuses, electromagnetic wave shielding sheets, electromagnetic wave shielding panels, electromagnetic wave shielding bags, electromagnetic wave shielding boxes, and electromagnetic wave shielding chambers.

[Examples]

The present invention will be specifically described based on Examples, Comparative Examples, and Reference Examples. The following Examples, Comparative Examples, and Reference Examples are only specific examples to facilitate understanding of the technical content of the present invention, and the technical scope of the present invention is not limited by these specific Examples.
In Table 1 below, the "Magnetic Layer" means the ferromagnetic layer and the "Conductive Layer" means the non-magnetic conductive metal layer.

[Preparation of Electromagnetic Wave Shielding Material]

Prepared in Examples 1-1 to 6, Comparative Examples 1 to 8, and Reference Examples 1 and 2, as shown in Table 1, were rolled copper foil TPC (tough pitch copper in accordance with JIS H3100 C1100, manufactured by JX Metals Corporation), electrodeposited copper foil STD (common electrolytic foil, manufactured by JX Metals Corporation) and electrodeposited copper foil for rigid substrates (manufactured by JX Metals Corporation) as the non-magnetic conductive metal layer, and commercially available permalloy and nickel foils as the ferromagnetic layer.
Next, in Examples 1-1, 2-5 and Reference Example 2, Cu-Co-Ni alloy plating was formed on the rolled copper foil TPC under the condition range as shown below. As a result, electromagnetic wave absorption auxiliary films (plated films) consisting of particle films of copper, cobalt, and nickel were formed on both surfaces of the rolled copper foil TPC, respectively. Further, a heat resistant film (plated film) consisting of cobalt and nickel was formed by a heat resistant plating treatment, a heat resistant film (plated film) consisting of nickel and zinc was formed by a heat resistant plating treatment, a rust preventive film (plated film) consisting of chromic acid was formed by a rust preventive treatment, and a weather resistant film (coated film) was formed by a silane coupling treatment. The thickness of each treated film is assumed to be 0.5 $\mu$m and is shown in the table.
On the other hand, in Example 1-2, an electromagnetic wave absorption auxiliary film (plated film) consisting of a particle film of copper, cobalt, and nickel, a heat resistant film (plated film) consisting of cobalt and nickel by plating, a heat resistant film (plated film) consisting of nickel and zinc by plating, a rust resistant film (plated film) consisting of chromic acid by plating, and a weather resistant film (coated film) by a silane coupling treatment were formed on one surface (upper surface) of the rolled copper foil TPC. The thickness of each treated films is assumed to be 0.5 $\mu$m and is shown in the table. On the other surface (lower surface) of the rolled copper foil TPC, a heat-resistant film (plated film) consisting of nickel and zinc was formed by plating, and a rust preventive film (plated film) consisting of chromic acid was formed by a rust preventive treatment, without forming the electromagnetic wave absorption auxiliary film (plated film). The thickness of each treated layer of the heat resistant and rust preventive films are assumed to be less than 0.1 $\mu$m, so the overall thickness of the electromagnetic wave shielding material in the table do not include the thickness of each treated film.
The bath composition and plating conditions used to form the electromagnetic wave absorption auxiliary film, the heat resistant plated film, the rust preventive film, and the weather resistant film are as follows. The following conditions were adjusted as needed according to the order of (A) to (E) below. The upper side of the rolled copper foil flowing in the conveying plating line is referred to as the upper surface and the lower side as the lower surface. In Example 1-2, in order to form a treated film on one surface of the rolled copper foil TPC, the current densities and Coulomb amounts in (A) through (D) below were adjusted as needed according to the conditions of the upper surface.

[Bath Composition and Plating Conditions]

(A) Electromagnetic wave absorption auxiliary film (Cu-Co-Ni alloy plating treatment (roughening plating treatment))

Liquid composition: 15.5 g/L of copper, 7.0 g/L of cobalt, 9.3 g/L of nickel;
pH: 2.3;
Liquid temperature: 36.0 °C;
Current density:

(Upper surface) first time: 21.3 A/dm$^2$, second time: 29.9 A/dm$^2$, third time: 56.8 A/dm$^2$;
(Lower surface) first time: 14.9 A/dm$^2$, second time: 26.1 A/dm$^2$, third time: 56.8 dm$^2$;

Coulomb amount:

(Upper surface) first time: 15.3 As/dm$^2$, second time: 21.5 As/dm$^2$, third time: 20.5 As/dm$^2$; and
(Lower surface) first time: 10.7 As/dm$^2$, second time: 18.8 As/dm$^2$, third time: 27.4 As/dm$^2$;

(B) Heat resistant film (Co-Ni alloy plating treatment)

Liquid composition: 12.5 g/L of nickel, 3.1 g/L of cobalt;
pH: 2.0;
Liquid temperature: 50 °C;
Current density: (upper surface) 17.5A/dm$^2$, (lower surface) 19.3A/dm$^2$; and
Coulomb amount: (upper surface) 6.3 As/dm$^2$, (lower surface) 6.9 A/dm$^2$;

(C) Heat resistant film (Ni-Zn alloy plating treatment)

Liquid composition: 23.5 g/L of nickel, 4.5 g/L of zinc;
pH: 3.7;
Liquid temperature: 40 °C;
Current density: (upper surface) 3.6 A/dm$^2$, (lower surface) 4.0 A/dm$^2$; and
Coulomb amount: (upper surface) 1.5 As/dm$^2$, (lower surface) 1.6 As/dm$^2$;

(D) Rust preventive film (electrolytic chromate treatment)

Liquid composition: 3.0 g/L of potassium dichromate, 0.33 g/L of zinc;
pH: 3.65;
Liquid temperature: 55 °C;
Current density:

(Upper surface) first time: 1.0 A/dm$^2$, second time: 1.0 A/dm$^2$;
(Lower surface) 1.1 A/dm$^2$;

Coulomb amount:

(Upper surface) first time: 0.7 As/dm$^2$, second time: 0.7 As/dm$^2$; and
(Lower surface) 0.8 As/dm$^2$;

(E) Weather resistant film (silane coupling treatment)

Silane coupling agent: glycidoxypropyltrimethoxysilane;
Concentration of silane coupling agent: 0.1% by volume;
Treatment temperature: 20 °C (room temperature); and
Treatment time: 5 seconds.

Next, in Example 6, Cu-Ni alloy plating was formed on the electrolytic copper foil under the condition ranges as shown below. As a result, an electromagnetic wave absorption auxiliary film (plated film) consisting of a particle film of copper and nickel was formed on one surface of the electrolytic copper foil as a treated film. The thickness of the treated film is assumed to be 0.5 μm and is shown in the table.

The bath composition and plating conditions used to form the electromagnetic wave absorption auxiliary film are as follows. The following conditions were adjusted as needed according to (F) below. The upper side of the rolled copper foil flowing in the conveying plating line is considered to be the upper surface.

[Bath Composition and Plating Conditions]

(F) Electromagnetic wave absorption auxiliary film (Cu-Ni alloy plating treatment (roughening plating treatment))
Liquid composition: 15.5 g/L of copper, 9.5 g/L of nickel;
pH: 2.4;
Liquid temperature: 36 °C;
Current density:
(Upper surface) first time: 44.7 A/dm$^2$, second time: 44.2 A/dm$^2$, third time: 63.2 A/dm$^2$, fourth time: 63. 2A/dm$^2$; and
Coulomb amount:
(Upper surface) first time: 17.4 As/dm$^2$, second time: 20.2 As/dm$^2$, third time: 19.3 As/dm$^2$, fourth time: 19.3 As/dm$^2$.

Next, in Comparative Examples 1 to 5 and Reference Example 1, rust preventive films were formed on both surfaces of the rolled copper foil TPC under the condition ranges as shown below. In Comparative Example 8, rust preventive films were formed on both surfaces of the electrodeposited copper foil STD under the following condition ranges. Since the thickness of each treated film, which is the rust preventive film, is assumed to be less than 0.1 μm, the overall thickness of the electromagnetic wave shielding material in the table does not include the thickness of each treated film.

The following conditions were adjusted as needed according to (g) below.

(G) Rust preventive film (benzotriazole treatment)
Liquid composition: 40 mg/L;
Liquid temperature: 20 °C (room temperature);
pH: 3.0;
Current density: 0 A/dm$^2$ (shower spray treatment); and
Processing time: 5 seconds.

Next, in Comparative Example 6, a smooth Ni plated film was formed on one surface of the electrodeposited copper foil under the condition ranges shown below. Furthermore, a rust preventive film was formed thereon under the condition ranges as shown below. In Comparative Example 7, smooth Ni plated films were formed on both surfaces of the electrodeposited copper foil STD under the following condition ranges. Furthermore, rust preventive films were formed thereon under the condition range as shown below.

The bath composition and plating conditions used are as follows. The following conditions were adjusted as needed according to the order of (H) to (I) below. The thickness of each treated film consisting of the smooth Ni film and the rust preventive film is assumed to be 0.5 μm and is shown in the table.

[Bath Composition and Plating Conditions]

(H) Smooth Ni film (Ni plating treatment)

Liquid composition: 55 g/L of nickel, 7.0 g/L of sodium citrate;
pH: 4.0;
Liquid temperature: 50 °C;
Current density: 4.0 A/dm$^2$; and
Coulomb amount: 350 As/dm$^2$;

(I) Rust preventive film (benzotriazole treatment)

Liquid composition: 40 mg/L;
Liquid temperature: 20 °C (room temperature);
pH: 3.0;
Current density: 0 A/dm$^2$ (shower spray treatment); and
Treatment time: 5 seconds.

In Example 1-1, an electromagnetic wave shielding material was obtained by alternately laminating a permalloy foil and a rolled copper foil TPC with treated films including copper, cobalt and nickel alloy plating formed on both surfaces, according to the configuration shown in Table 1. In Example 1-2, a permalloy foil and a rolled copper foil TPC with a treated film including copper, cobalt and nickel alloy plating formed on one surface and a treated film consisting of a heat resistant film and a rust preventive film formed on the other surface were prepared according to the configuration shown in Table 1, and the permalloy foil and the rolled copper foil were alternately laminated so as to sandwich the permalloy foil between the two treated films of the rolled copper foil TPC (treated films including copper, cobalt and nickel alloy plating) to obtain an electromagnetic wave shielding material. In each of Examples 2 to 5, an electromagnetic wave shielding material was obtained by alternately laminating a nickel foil and a rolled copper foil TPC with treated films including copper, cobalt and nickel alloy plating formed on both surfaces, according to the configuration shown in Table 1. In Example 6, a permalloy foil and an electrodeposited copper foil with a treated film including copper and nickel alloy plating formed on one surface were prepared according to the configuration as shown in Table 1, and the permalloy foil and electrodeposited copper foil were alternately laminated so as to sandwich the permalloy foil between the two treated films of the electrodeposited copper foil to obtain an electromagnetic wave shielding material. In Reference Example 2, treated films including copper, cobalt and nickel alloy plating were formed on both surfaces of the rolled copper foil TPC to obtain an electromagnetic wave shielding material, according to the configuration as shown in Table 1.

In each of Comparative Examples 1 to 5, an electromagnetic wave shielding material was obtained by alternately laminating a permalloy foil or a nickel foil and a rolled copper foil TPC with rust preventive films formed on both surfaces. In Comparative Example 6, a permalloy foil and an electrodeposited copper foil with treated films consisting of a smooth Ni film and a rust preventive film formed on both surfaces were prepared according to the configuration as shown in Table 1, and the permalloy foil and the electrodeposited copper foil were alternately laminated to sandwich the permalloy foil between the two treated films of the electrodeposited copper foil to obtain an electromagnetic wave shielding material. In Comparative Example 7, an electromagnetic wave shielding material was obtained by alternately laminating a permalloy foil and an electrodeposited copper foil STD with treated films consisting of a smooth Ni film and a rust preventive film formed on both surfaces, according to the configuration as shown in Table 1. In Comparative Example 8, an electromagnetic wave shielding material was obtained by alternately laminating a permalloy foil and an electrodeposited copper foil STD with rust preventive films formed on both surfaces, according to the configuration shown in Table 1. In Reference Example 1, an electromagnetic wave shielding material with rust preventive films formed on both surfaces of a rolled copper foil TPC was obtained. In each of Examples 1-1 to 6 and Comparative Examples 1 to 8, the edges of the obtained electromagnetic wave shielding material were joined with a single-sided tape.

<Evaluation Method>

(Evaluation of Shieling Property)

The electromagnetic wave shielding material was disposed in a magnetic field shielding property evaluation device (Techno Science Japan Model T SES-KEC) by fixing top and bottom four corners of a jig for KEC so that the rolled copper foil TPC or the electrodeposited copper foil forming the electromagnetic wave shielding material, and the permalloy foil or the nickel foil would not shift their positions during the measurement. The electromagnetic wave shielding materials obtained in Examples 1-1 to 6, Comparative Examples 1 to 8, and Reference Examples 1 and 2 were evaluated for their magnetic field shielding properties for a frequency of 100 kHz and at room temperature (25 °C) by the KEC method using the magnetic field shielding property evaluation device. The results are shown in Table 1.

(Weather Resistance)

Each electromagnetic wave shielding material was placed in a constant temperature and humidity device at 85 °C and 85% Rh, and the weather resistance was evaluated by confirming the discoloration on the surface of the electromagnetic wave shielding material after 200 hours (after standing). A case where no discoloration was observed on the surface of the electromagnetic wave shielding material before and after standing in the device was determined to be good ("circle"), while a case where the discoloration was observed was determined to be poor ("x"). The results are shown in Table 1.

(Measurement of Adhesion Amount)

Samples were rolled copper foils with treated films formed on the rolled copper foil TPC obtained under the same conditions as in Examples 1-1 to 5 and Reference Example 2. To measure the amounts of various metals other than copper adhering to the treated films, a film on a 50 mm $\times$ 50 mm copper foil surface was dissolved in an aqueous $HNO_3$ (30% by volume) solution, and concentrations of metals in a 10-fold diluted aqueous solution of that solution were quantified by ICP emission spectrometer (SFC-3100, manufactured by SII Nanotechnology Co., Ltd.), and the amount of metal per unit area ($\mu$g/dm$^2$) was calculated and derived. In this case, masking was performed as necessary to prevent contamination of the amounts of metals adhering on the surface opposite to the surface to be measured, and the analysis was performed. The mass ratio of cobalt in each treated film was 2.3 on the upper surface side and 2.1 on the lower surface side of the rolled copper foil, assuming that the mass ratio of nickel in each treated film was 1. In other words, in Example 1-1 and Examples 2 to 5 and Reference Examples 2 where the treated films including copper, cobalt and nickel alloy plating were formed on both surfaces, the mass ratio of cobalt in each treated film was considered to be 2.3 for the upper surface and 2.1 for the lower surface of the rolled copper foil, and in Example 1-2 where the treated film including copper, cobalt and nickel alloy plating was formed on one surface (the upper surface of the rolled copper foil), the mass ratio of cobalt in the treated film on the upper surface of the rolled copper foil was considered to be 2.3.

The mass ratio in the treated film was calculated using the following equation (2):

Mass ratio of cobalt in each treated film assuming that the mass ratio of nickel in each treated film is 1 = [amount of Co adhering on treated film ($\mu$g/dm$^2$)/amount of Ni adhering on treated film ($\mu$g/dm$^2$)]     (2)

[TABLE 1]

EP 4 489 540 A1

| | Electromagnetic Shielding Material | | Magnetic Layer | | Conductive Layer | | Treated Film | | Evaluation Results | |
|---|---|---|---|---|---|---|---|---|---|---|
| | Configuration of Structure | Overall Thickness [μm] | Materials | Thickness of Each Layer [μm] | Materials | Thickness of Each Layer [μm] | Presence or Absence of Treated Film Containing Alloy Plating Including Cu-Ni | Presence or Absence of Treated Film Consisting of Smooth Ni Film and Rust Preventive Film | Electromagnetic Shielding Property for Frequency of 100 kHz [dB] | Weather Resistance |
| Example 1-1 | Conductive Layer/Magnetic Layer/Conductive Layer | 86 | Permalloy Foil | 50 | Cu Foil (TPC) | 17 | Present (Both Sides) | Absent | 20.2 | ○ |
| Example 1-2 | Conductive Layer/Magnetic Layer/Conductive Layer | 85 | Permalloy Foil | 50 | Cu Foil (TPC) | 17 | Present (One Side) | Absent | 18.9 | ○ |
| Comparative Example 1 | Conductive Layer/Magnetic Layer/Conductive Layer | 84 | Permalloy Foil | 50 | Cu Foil (TPC) | 17 | Absent | Absent | 18.3 | × |
| Example 2 | Conductive Layer/Magnetic Layer/Conductive Layer | 86 | Ni Foil | 50 | Cu Foil (TPC) | 17 | Present (Both Sides) | Absent | 18.2 | ○ |
| Comparative Example 2 | Conductive Layer/Magnetic Layer/Conductive Layer | 84 | Ni Foil | 50 | Cu Foil (TPC) | 17 | Absent | Absent | 18.1 | × |
| Example 3 | Magnetic Layer/Conductive Layer/Magnetic Layer/Conductive Layer | 136 | Ni Foil | 50 | Cu Foil (TPC) | 17 | Present (Both Sides) | Absent | 21.0 | ○ |
| Comparative Example 3 | Magnetic Layer/Conductive Layer/Magnetic Layer/Conductive Layer | 134 | Ni Foil | 50 | Cu Foil (TPC) | 17 | Absent | Absent | 20.7 | × |
| Example 4 | Conductive Layer/Magnetic Layer/Conductive Layer/Magnetic Layer/Conductive Layer | 154 | Ni Foil | 50 | Cu Foil (TPC) | 17 | Present (Both Sides) | Absent | 24.7 | ○ |
| Comparative Example 4 | Conductive Layer/Magnetic Layer/Conductive Layer/Magnetic Layer/Conductive Layer | 151 | Ni Foil | 50 | Cu Foil (TPC) | 17 | Absent | Absent | 24.0 | × |
| Example 5 | Conductive Layer/Magnetic Layer/Conductive Layer/Magnetic Layer/Conductive Layer/Magnetic Layer/Conductive Layer | 222 | Ni Foil | 50 | Cu Foil (TPC) | 17 | Present (Both Sides) | Absent | 31.1 | ○ |
| Comparative Example 5 | Conductive Layer/Magnetic Layer/Conductive Layer/Magnetic Layer/Conductive Layer/Magnetic Layer/Conductive Layer | 218 | Ni Foil | 50 | Cu Foil (TPC) | 17 | Absent | Absent | 30.5 | × |
| Example 6 | Conductive Layer/Magnetic Layer/Conductive Layer | 85 | Permalloy Foil | 50 | Cu Foil (For Rigid Substrate) | 17 | Present (One Side) | Absent | 19.0 | × |
| Comparative Example 6 | Conductive Layer/Magnetic Layer/Conductive Layer | 86 | Permalloy Foil | 50 | Cu Foil (For Rigid Substrate) | 17 | Absent | Present (Both Sides) | 18.5 | × |
| Comparative Example 7 | Conductive Layer/Magnetic Layer/Conductive Layer | 86 | Permalloy Foil | 50 | Cu Foil (STD) | 17 | Absent | Present (Both Sides) | 17.5 | × |
| Comparative Example 8 | Conductive Layer/Magnetic Layer/Conductive Layer | 84 | Permalloy Foil | 50 | Cu Foil (STD) | 17 | Absent | Absent | 17.9 | × |
| Reference Example 1 | Conductive Layer | 17 | — | — | Cu Foil (TPC) | 17 | Absent | Absent | 10.2 | × |
| Reference Example 2 | Conductive Layer | 18 | — | — | Cu Foil (TPC) | 17 | Present (Both Sides) | Absent | 10.1 | ○ |

[Discussion by Examples]

When comparing Reference Example 1 with Reference Example 2, the shielding property in the low-frequency region was deteriorated even if at least one surface of the non-magnetic conductive metal layer included the treated film containing the alloy including copper and nickel. In other words, even if at least one surface of the non-magnetic conductive metal layer includes the treated film containing the alloy including copper and nickel, it is difficult to expect an improved shielding property in the low frequency range. On the other hand, in Examples 1-1 to 6, the shielding property in the low frequency region was good by having the treated film containing the alloy including copper and nickel on at least one surface of the non-magnetic conductive metal layer, as compared with the corresponding Comparative Examples 1 to 6, and Examples 1-1 to 6 had a ferromagnetic layer as compared with Reference Example 2. From these points, it can be seen that by having the ferromagnetic layer and the non-magnetic conductive metal layer, and further having the treated film containing the alloy including copper and nickel on at least one surface of the non-magnetic conductive metal layer, the electromagnetic wave shielding material showing the good shielding property in the low frequency range was obtained. Also, when comparing Comparative Example 7 with Comparative Example 8, it can be seen that if the treated film on at least one surface of the non-magnetic conductive metal layer is not appropriate, it is difficult to expect the improved shielding property.

It should be noted that Examples 1-1 to 5 had good weather resistance, because at least one outermost layer of the electromagnetic wave shielding material was the non-magnetic conductive metal layer, which had the rust preventive film or the weather resistant film contained in the treated film formed on the outer surface of the non-magnetic conductive metal layer.

## Claims

1.  An electromagnetic wave shielding material having a structure in which at least one ferromagnetic layer and at least one non-magnetic conductive metal layer is laminated together,
    wherein the electromagnetic wave shielding material further comprises a treated film containing an alloy comprising copper and nickel on at least one surface of the non-magnetic conductive metal layer.

2.  The electromagnetic wave shielding material according to claim 1, wherein the structure has ferromagnetic layers laminated via at least two non-magnetic conductive metal layers.

3.  The electromagnetic wave shielding material according to claim 1, wherein at least one outermost layer is the non-magnetic conductive metal layer.

4.  The electromagnetic wave shielding material according to any one of claims 1 to 3, wherein the alloy contained in the treated layer further comprises cobalt.

5.  The electromagnetic wave shielding material according to claim 4, wherein a mass ratio of cobalt in each treated film is 1.50 to 4.50 assuming that the mass ratio of nickel in each treated layer is 1.

6.  A covering material or an exterior material for electrical and electronic apparatuses, the covering material or the exterior material comprising the electromagnetic wave shielding material according to any one of claims 1 to 5.

7.  An electrical and electronic apparatus comprising the covering material or the exterior material according to claim 6.

<div align="center">

**INTERNATIONAL SEARCH REPORT**

</div>

| | International application No. |
|---|---|
| | **PCT/JP2022/039178** |

**A. CLASSIFICATION OF SUBJECT MATTER**

*H05K 9/00*(2006.01)i; *B32B 15/01*(2006.01)i; *H01F 1/14*(2006.01)i
FI:  H05K9/00 W; H01F1/14; B32B15/01 Z

According to International Patent Classification (IPC) or to both national classification and IPC

**B. FIELDS SEARCHED**

Minimum documentation searched (classification system followed by classification symbols)

H05K9/00; B32B15/01; H01F1/14

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2010-206182 A (TOSHIBA CORP) 16 September 2010 (2010-09-16) paragraphs [0013]-[0016], [0031], fig. 1, 12 | 1-7 |
| Y | JP 62-256498 A (KAWASAKI STEEL CORP) 09 November 1987 (1987-11-09) p. 2, lower right column, line 15 to p. 3, upper left column, line 12, p. 4, upper left column, lines 3-5, fig. 2 | 1-7 |
| Y | JP 2007-332408 A (SUMITOMO METAL MINING CO LTD) 27 December 2007 (2007-12-27) paragraphs [0035]-[0036], [0050] | 1-7 |
| Y | JP 2007-335619 A (SUMITOMO METAL MINING CO LTD) 27 December 2007 (2007-12-27) paragraph [0047] | 1-7 |
| Y | JP 2017-076586 A (NITTO DENKO CORP) 20 April 2017 (2017-04-20) paragraphs [0002], [0061]-[0065] | 1-7 |

☐ Further documents are listed in the continuation of Box C.     ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 December 2022** | **17 January 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/039178**

| Patent document cited in search report | | | Publication date (day/month/year) | Patent family member(s) | Publication date (day/month/year) |
|---|---|---|---|---|---|
| JP | 2010-206182 | A | 16 September 2010 | (Family: none) | |
| JP | 62-256498 | A | 09 November 1987 | (Family: none) | |
| JP | 2007-332408 | A | 27 December 2007 | (Family: none) | |
| JP | 2007-335619 | A | 27 December 2007 | (Family: none) | |
| JP | 2017-076586 | A | 20 April 2017 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021028940 A

**Non-patent literature cited in the description**

- **KIYOSHI MARUYAMA**. Plating Practice Handbook. Nikkan Kogyo Shimbun, Ltd, 30 June 1983, 157-160